# EUROPEAN PATENT SPECIFICATION

(11) **EP 2 416 498 B1**
(45) Date of publication and mention of the grant of the patent: **15.04.2015**
(21) Application number: 11382268.8
(22) Date of filing: 03.08.2011
(51) Int. Cl.: H03K 17/96, F24C 7/08

(54) **Control device adapted to a household appliance, in particular to a glass-ceramic cooking appliance**
An ein Haushaltsgerät angepasste Steuerungsvorrichtung, insbesondere an eine Glas-Keramik-Kochanwendung
Dispositif de contrôle adapté à un appareil domestique, en particulier à un appareil de cuisson en vitrocéramique

(30) Priority: 05.08.2010 ES 201030835 U
(43) Date of publication of application: 08.02.2012
(73) Proprietor: Eika, S.Coop, 48277 Etxebarria (ES)
(72) Inventor: De Los Toyos López, Daniel, 20600 Eibar (Gipuzkoa) (ES); Etxebarrieta Alonso, Agustín, 48393 Forua (ES)
(74) Representative: Igartua, Ismael

(56) References cited:
- EP-A2- 1 416 636
- DE-U1-202009 009 373
- FR-A1- 2 503 493

## Description

### TECHNICAL FIELD

This invention relates to a control device adapted to a household appliance, in particular to a glass-ceramic cooking appliance that comprises at least one heat source arranged beneath a cooking hob.

### PRIOR ART

There are known household heating appliances, in particular glass-ceramic cooking appliances that comprise touch keys that include capacitive sensors. Said touch keys are arranged between the cooking hob and a printed circuit board arranged substantially parallel to said cooking hob. ES2130770T3 thus discloses that the capacitive key is a single piece formed by a leaf spring made of an electrically conductive material that includes a base that is arranged fixed to the printed circuit board, a substantially flat top part adapted to make contact with the interior of the cooking hob, and a flexible middle part that enables the continuous contact of the top surface against the printed circuit board. As a result, when the user places a finger on the cooking hob, on the touch key, the circuit is connected to ground by means of the user's body, the control device of the glass-ceramic cooker detecting a variation in the output signal.

In addition, US20070103451A describes a contact switch that includes a capacitive sensor arranged beneath the cooking hob, in electrical contact with the printed circuit board. The capacitive sensor comprises a compression spring and an electrically conductive contact member arranged on the cooking hob, one of the ends of the spring being arranged facing the cooking hob and the opposite end in electrical contact with the contact member.

ES2035759T3 describes how each capacitive key is made up of two metal frames or electrodes, arranged in a single plane, arranged supported on a printed circuit board located beneath the cooking hob. One of the frames of the condenser surrounds the other frame with the result that the approach of a finger to the vertical of the condenser modifies its capacity, causing a change of state. The printed circuit board is arranged against the cooking hob, in particular, by means of a thin layer of resin that is placed between both.

Finally, ES1068526U and DE 20 2009 009 373 U1 describe a control device wherein the capacitive touch keys, each of which comprises a transmitter electrode and a receiver electrode linked in a capacitive manner to the transmitter electrode, are arranged on a printed circuit board arranged beneath the cooking hob, there being arranged between the cooking hob and the printed circuit board an intermediate member made of a non-electrically conductive material that is adapted to the inner surface of the cooking hob.

### DISCLOSURE OF THE INVENTION

The object of the invention is to provide a control device adapted to a household appliance, in particular to a glass-ceramic cooking appliance that comprises at least one heater arranged beneath a cooking hob, as described in the claims.

The control device according to the invention comprises at least one capacitive touch key that is arranged beneath the cooking hob, a printed circuit board on which is arranged the touch key, and at least one electrically insulating intermediate member, which is arranged between the touch key and an inner surface of the cooking hob.

In addition, the touch key comprises at least one terminal that projects out in a direction towards the cooking hob. As a result, the intermediate member is adapted perfectly to the inner surface of the cooking hob, preventing air gaps between both members, and, thanks to the terminal, the touch key is brought closer to the cooking hob, reducing the dielectric between both members.

Finally, an optimised control device that is easy to assemble is obtained, with all the necessary electronic members built into the printed circuit board.

These and other advantages and characteristics of the invention will be made evident in the light of the drawings and the detailed description thereof.

### DESCRIPTION OF THE DRAWINGS

Figure 1 is a view in perspective of a glass-ceramic cooking appliance that comprises a control device according to the invention.
Figure 2 is a cross-sectional view of the control device comprised in the glass-ceramic cooking appliance shown in Figure 1.
Figure 3 is a view of the printed circuit board comprised in the control device shown in Figure 2.

### DETAILED DISCLOSURE OF THE INVENTION

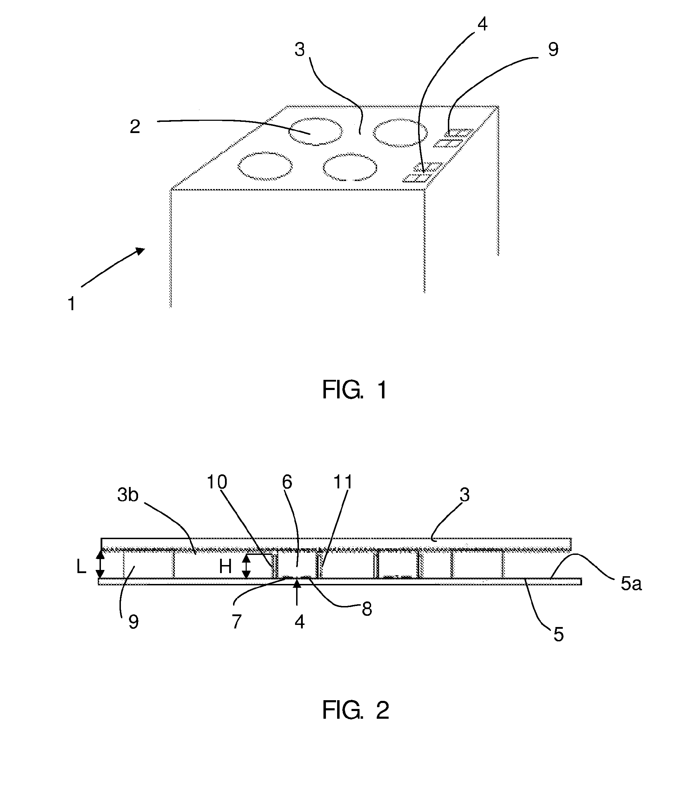

Figure 1 shows a glass-ceramic cooking appliance 1 that comprises heaters 2 arranged beneath a glass-ceramic cooking hob 3, and a control device through which a user controls the switching-off and switching-on and the power supplied to said heaters 2.

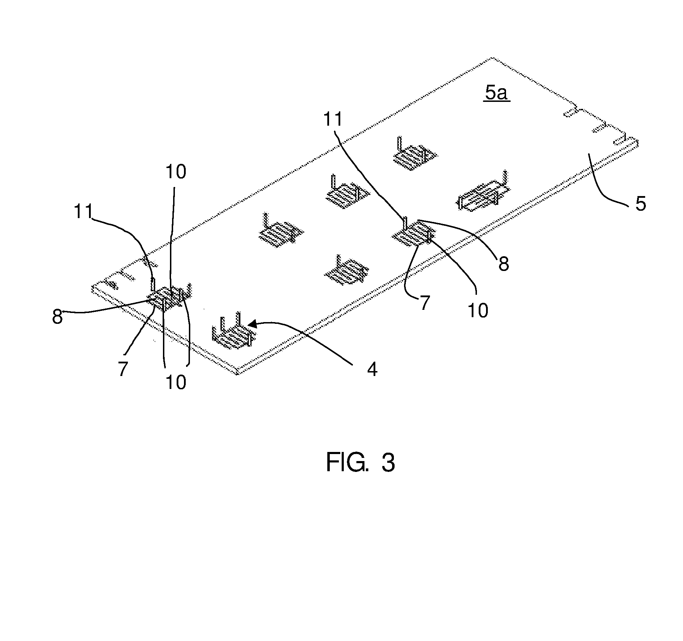

The control device, shown in detail in Figures 2 and 3, comprises a printed circuit board 5 that is arranged beneath the cooking hob 3, and capacitive touch keys 4, each of which comprises a transmitter electrode 7 and a receiver electrode 8, which are arranged deposited on the printed circuit board 5 to form a conductive imprint, as shown in Figure 3.

Each touch key 4 comprises at least one terminal 10,11, made of an electrically conductive material. Preferably, each touch key 4 comprises at least one terminal 10 associated to the transmitter electrode 7 and at least one terminal 11 associated to the receiver electrode 8, four being the maximum number of terminals 10,11 associated to each electrode 7,8.

In the embodiment shown in Figures 2 and 3, each terminal 10,11 has a substantially cylindrical shape, its thickness being between, approximately, 0,1 mm and, approximately, 3 mm, and preferably between, approximately, 0,5 mm and approximately, 2 mm.

Furthermore, each terminal 10,11 projects out in relation to the printed circuit board 5 in a direction towards the cooking hob 3, being arranged substantially orthogonal to said printed circuit board 5.

Each terminal 10,11 has a height H of between, approximately, 1 mm and, approximately, 10 mm, the height H preferably, being between, approximately, 2 mm and, approximately, 4 mm.

The control device also comprises an intermediate member 6 that is arranged between each touch key 4 and the cooking hob 3, said intermediate member 6 being detachable in relation to the printed circuit board 5. The intermediate member 6 is made of an electrically insulating material, with good dielectric properties. In addition, said intermediate member 6 has to withstand high temperatures to prevent deformations caused by the heat of the cooking hob 3 or of cooking receptacles arranged on said cooking hob 3. In the embodiment shown in the figures, the intermediate member 6 is flexible so that it may adapt itself perfectly to the inner surface 3b, which is rough, of the cooking hob 3. As a result, the air that exists between the corresponding touch key 4 and said surface 3b is reduced, the dielectric between both being reduced as a result. The intermediate member 6 comprises a polymeric material, preferably a silicone foam, the apparent preferred density of said silicone foam being 0,5 g/ml.

The intermediate member 6 has a thickness of between, approximately, 1 mm and, approximately, 10 mm, the preferred thickness for a silicone foam with a density of 0,5 g/ml being between, approximately, 3 mm and, approximately, 4,5 mm, said intermediate member 6 being arranged compressed between the cooking hob 3 and the printed circuit board 5 when the cooking hob 3 has been fitted, preventing any air gap between the cooking hob 3 and said intermediate member 6.

In addition, the intermediate member 6 is arranged fixed to the printed circuit board 5 by friction against the corresponding terminal 10,11. Preferably, the corresponding terminal 10,11 is arranged inserted in the intermediate member 6, said intermediate member 6 being detachable in relation to said printed circuit board 5. In other embodiments not shown in the figures, the fixing of the intermediate member 6 to the corresponding touch key 4 and, therefore, to the printed circuit board 5, may be reinforced by the use of known adhesive means.

Additionally, in the embodiment shown in Figure 2, the intermediate member 6 comprises a single body that is arranged supported on the corresponding touch key 4. In other embodiments not shown in the figures, the control device may include a single intermediate member 6 arranged on a plurality of touch keys 4, said intermediate member 6 being passed in this case through by the corresponding terminals 10,11.

In other embodiments not shown in the figures, the intermediate element 6 can be made of a substantially rigid material, with a thickness of between, approximately, 1 mm and, approximately, 10 mm. With this intermediate element, the dielectric between the touch key 4 and the cooking hob is reduced. Moreover, in these embodiments, not shown, the intermediate element comprises the corresponding terminals embedded in said intermediate element, the fixing of said intermediate element to the touch key may be enforced by the use of known adhesive means.

Finally, the control device comprises light indicator means 9, associated to each heater 2, which are arranged fixed on the printed circuit board 5 and which show the user the power level at which the corresponding heater 2 is operating. The light indicator means 9 are arranged on the surface 5a of the printed circuit board 5 on which are arranged deposited the touch keys 4, with the result that a single printed circuit board 5 is used both for the light indicator means and for the touch keys 4.

## Claims

1. Control device adapted to a household appliance, in particular to a glass-ceramic cooking appliance (1), that comprises at least one heater (2) arranged beneath a cooking hob (3), the control device comprising at least one capacitive touch key (4) that is arranged beneath the cooking hob (3), a printed circuit board (5) on which is arranged the touch key (4), and at least one electrically insulating intermediate member (6) that is arranged between the touch key (4) and an inner surface (3b) of the cooking hob (3), the touch key (4) comprising at least one transmitter electrode (7) and at least one receiver electrode (8),
wherein
the touch key (4) further comprises at least one terminal (10,11) arranged associated to each electrode (7,8), that projects out in a direction towards the cooking hob (3), **characterised in that** the intermediate member (6) is arranged fixed to the printed circuit board (5) by friction against the corresponding terminal (10,11) associated to each electrode (7, 8).

2. Control device according to the preceding claim, wherein the touch key (4) comprises a plurality of terminals (10,11) associated to each electrode (7,8).

3. Control device according to any of the preceding claims, wherein the touch key (4) comprises up to a maximum of four terminals (10,11) associated to each electrode (7,8).

4. Control device according to any of the preceding claims, wherein each terminal (10,11) has a height (H) of between, approximately, 1 mm and, approximately, 10 mm.

5. Control device according to the preceding claim, wherein the height (H) is preferably between, approximately, 2 mm and, approximately, 4 mm.

6. Control device according to any of the preceding claims, wherein each transmitter electrode (7) and each receiver electrode (8) are arranged deposited on the printed circuit board (5).

7. Control device according to any of the preceding claims, wherein the intermediate member (6) is made of a compressible material adaptable to the inner surface (3b), said intermediate member (6) being arranged compressed between the cooking hob (3) and the printed circuit board (5), when the cooking hob (3) has been fitted.

8. Control device according to any of the preceding claims, wherein the corresponding terminal (10,11) is arranged inserted in the intermediate member (6).

9. Control device according to any of claims 1 to 6, wherein the intermediate member (6) is made of a substantially rigid material.

10. Control device according to the preceding claim, wherein the corresponding terminal (10,11) is arranged embedded in the intermediate element (6).

11. Control device according to claims 8 or 10, wherein the fixing of the corresponding terminal (10,11) to the intermediate member (6) is reinforced by the use of adhesive means.

12. Control device according to claims 8 or 10, wherein the intermediate member (6) is arranged in a detachable manner in relation to the printed circuit board (5).

## Patentansprüche

1. An ein Haushaltsgerät angepasste Steuervorrichtung, insbesondere an eine Glas-Keramik-Kochanwendung (1), die mindestens eine Heizvorrichtung (2) umfasst, die unter einer Kochstelle (3) angeordnet ist, wobei die Steuervorrichtung mindestens eine kapazitive Berührungstaste (4) umfasst, die unter der Kochstelle (3) angeordnet ist, eine Leiterplatte (5), auf der die Berührungstaste (4) angeordnet ist, und mindestens ein elektrisch isolierendes Zwischenelement, (6) das zwischen der Berührungstaste (4) und einer inneren Fläche (3b) der Kochstelle (3) angeordnet ist, wobei die Berührungstaste (4) mindestens eine Sendeelektrode (7) und mindestens eine Empfängerelektrode (8) umfasst, wobei die Berührungstaste (4) weiter mindestens ein Endgerät (10, 11) umfasst, das mit jeder Elektrode (7, 8) assoziiert angeordnet ist, die in einer Richtung hin zur Kochstelle (3) hervorspringt, **dadurch gekennzeichnet, dass** das Zwischenelement (6) an die Leiterplatte (5) durch Reibung gegen das entsprechende Endgerät (10, 11), das mit jeder Elektrode (7, 8) assoziiert ist, befestigt angeordnet ist.

2. Steuervorrichtung nach dem vorhergehenden Anspruch, wobei die Berührungstaste (4) eine Vielzahl von Endgeräten (10, 11) umfasst, die mit jeder Elektrode (7, 8) assoziiert sind.

3. Steuervorrichtung nach einem der vorhergehenden Ansprüche, wobei die Berührungstaste (4) bis zu einem Maximum von vier Endgeräten (10, 11) umfasst, die mit jeder Elektrode (7, 8) assoziiert sind.

4. Steuervorrichtung nach einem der vorhergehenden Ansprüche, wobei jedes Endgerät (10, 11) eine Höhe (H) von zwischen ungefähr 1 mm und, ungefähr 10 mm aufweist.

5. Steuervorrichtung nach dem vorhergehenden Anspruch, wobei die Höhe (H) vorzugsweise zwischen ungefähr 2 mm und ungefähr 4 mm liegt.

6. Steuervorrichtung nach einem der vorhergehenden Ansprüche, wobei jede Sendeelektrode (7) und jede Empfängerelektrode (8) auf der Leiterplatte (5) aufgebracht angeordnet ist.

7. Steuervorrichtung nach einem der vorhergehenden Ansprüche, wobei das Zwischenelement (6) aus einem komprimierbaren Material hergestellt ist, das auf die innere Fläche (3b) angepasst werden kann, wobei das Zwischenelement (6) zwischen der Kochstelle (3) und der Leiterplatte (5) komprimiert angeordnet ist, wenn die Kochstelle (3) passend gemacht wurde.

8. Steuervorrichtung nach einem der vorhergehenden Ansprüche, wobei das entsprechende Endgerät (10, 11) in das Zwischenelement (6) eingeführt angeordnet ist.

9. Steuervorrichtung nach einem der Ansprüche 1 bis 6, wobei das Zwischenelement (6) aus einem im Wesentlichen starren Material hergestellt ist.

10. Steuervorrichtung nach dem vorhergehenden Anspruch, wobei das entsprechende Endgerät (10, 11) im Zwischenelement (6) eingebettet angeordnet ist.

11. Steuervorrichtung nach Anspruch 8 oder 10, wobei die Befestigung des entsprechenden Endgeräts (10, 11) an das Zwischenelement (6) durch die Verwendung von haftenden Mitteln verstärkt ist.

12. Steuervorrichtung nach Anspruch 8 oder 10, wobei das Zwischenelement (6) auf eine abnehmbare Weise mit Bezug auf die Leiterplatte (5) angeordnet ist.

## Revendications

1. Dispositif de commande adapté à un appareil ménager, et plus particulièrement à un appareil de cuisson vitrocéramique (1), qui comprend au moins un réchauffeur (2) placé sous une plaque de cuisson (3), le dispositif de commande comprenant au moins une touche tactile capacitive (4) placée sous la table de cuisson (3), une carte de circuit imprimé (5) sur laquelle est placée la touche tactile (4), et au moins un élément intermédiaire électriquement isolant (6) placé entre la touche tactile (4) et une surface intérieure (3b) de la plaque de cuisson (3), la touche tactile (4) comprenant au moins une électrode de transmission (7) et au moins une électrode de réception (8), dans lequel la touche tactile (4) comprend en outre au moins une borne (10, 11) associée à chaque électrode (7, 8), et qui se projette vers l'extérieur dans une direction qui va vers la plaque de cuisson (3), **caractérisé en ce que** l'élément intermédiaire (6) est fixé sur la carte de circuit imprimé (5) par frottement contre la borne correspondante (10, 11) associée à chaque électrode (7, 8).

2. Dispositif de commande selon la revendication précédente, dans lequel la touche tactile (4) comprend une pluralité de bornes (10, 11) associées à chaque électrode (7, 8).

3. Dispositif de commande selon l'une quelconque des revendications précédentes, dans lequel la touche tactile (4) comprend quatre bornes (10, 11) au maximum, associées à chaque électrode (7, 8).

4. Dispositif de commande selon l'une quelconque des revendications précédentes, dans lequel chaque borne (10, 11) possède une hauteur (H) comprise entre environ 1 mm et environ 10 mm.

5. Dispositif de commande selon la revendication précédente, dans lequel la hauteur (H) est de préférence comprise entre environ 2 mm et environ 4 mm.

6. Dispositif de commande selon l'une quelconque des revendications précédentes, dans lequel chaque électrode de transmission (7) et chaque électrode de réception (8) est déposée sur la carte de circuit imprimé (5).

7. Dispositif de commande selon l'une quelconque des revendications précédentes, dans lequel l'élément intermédiaire (6) est composé d'un matériau compressible adaptable à la surface intérieure (3b), ledit élément intermédiaire (6) étant compressé entre la plaque de cuisson (3) et la carte de circuit imprimé (5), lorsque la plaque de cuisson (3) a été installée.

8. Dispositif de commande selon l'une quelconque des revendications précédentes, dans lequel la borne correspondante (10, 11) est insérée dans l'élément intermédiaire (6).

9. Dispositif de commande selon l'une quelconque des revendications précédentes 1 à 6, dans lequel l'élément intermédiaire (6) est composé d'un matériau sensiblement rigide.

10. Dispositif de commande selon la revendication précédente, dans lequel la borne correspondante (10, 11) est intégrée à l'élément intermédiaire (6).

11. Dispositif de commande selon les revendications 8 ou 10, dans lequel la fixation de la borne correspondante (10, 11) sur l'élément intermédiaire (6) est renforcée par l'utilisation d'un adhésif.

12. Dispositif de commande selon les revendications 8 ou 10, dans lequel l'élément intermédiaire (6) est placé de manière détachable par rapport à la carte de circuit imprimé (5).
